# FASCICULE DE BREVET EUROPEEN

(11) **EP 1 835 339 B1**
(45) Date de publication et mention de la délivrance du brevet: **16.05.2012**
(21) Numéro de dépôt: 06405114.7
(22) Date de dépôt: 15.03.2006
(51) Int. Cl.: G03F 7/00

(54) **Procédé de fabrication par technologie de type liga d'une structure métallique monocouche ou multicouche, et structure obtenue**
LIGA Verfahren zur Herstellung einer einzel- oder mehrlagigen metallischen Struktur und damit hergestellte Struktur
Fabrication process by LIGA type technology, of a monolayer or multilayer metallic structure, and structure obtained therewith

(43) Date de publication de la demande: 19.09.2007
(73) Titulaire: Rolex S.A., 1211 Genève 26 (CH)
(72) Inventeur: Saucy, Clément, CH-2520 La Neuveville (CH)
(74) Mandataire: Moreau, Stéphane Michel

(56) Documents cités:
- EP-A- 1 331 528
- EP-A- 1 596 259
- EP-A1- 0 851 295
- EP-A1- 0 955 632
- US-A- 5 234 571
- US-A- 5 766 441
- US-A1- 2003 062 652
- US-A1- 2005 056 074
- DAS S S ET AL: "Adhesion promotion by surface-modification at the PMMA-metal interface for LIGA-type processing" MICROELECTROMECHANICAL STRUCTURES FOR MATERIALS RESEARCH. SYMPOSIUM MATER. RES. SOC WARRENDALE, PA, USA, 1998, pages 149-154, XP008069843 ISBN: 1-55899-424-6

## Description

La présente invention concerne un nouveau procédé de fabrication par une technologie de type LIGA d'une structure métallique monocouche ou multicouche, ainsi qu'une nouvelle structure métallique monocouche ou multicouche susceptible d'être obtenue par ce procédé.

DGC Mitteilungen No. 104, 2005, mentionne l'utilisation de la technologie LIGA (LIthographie Galvanik Abformung : méthode conçue par W. Ehrfeld du Karlsruhe Nuclear Research Center, Allemagne) pour la fabrication de pièces métalliques horlogères de haute précision, telles que par exemple des ancres ou des roues d'échappement. Ce procédé présente l'inconvénient de nécessiter un équipement lourd, un synchrotron, pour générer l'irradiation en rayons X. Il ne peut donc connaître une utilisation large dans l'industrie horlogère.

A.B. Frazier et al., Journal of Microelectromechanical systems, Vol. 2, N°2, June 1993, décrit la fabrication de structures métalliques par électrodéposition de métal dans des moules en photorésist à base de polyimide, préparés à l'aide d'un procédé utilisant une technologie appelée LIGA-UV, analogue à la technologie LIGA mais avec une illumination UV à la place de l'irradiation aux rayons X.

Le procédé utilisé pour la fabrication de structures métalliques monocouches comprend les étapes suivantes :
- créer sur une plaquette support en silicium une couche métallique sacrificielle et une couche d'ensemencement pour l'électrodéposition,
- étaler par dépôt à la tournette (spin-coating) une couche de polyimide photosensible,
- effectuer à travers un masque correspondant à l'empreinte désirée une illumination UV,
- développer en dissolvant les parties non irradiées de façon à obtenir un moule en polyimide,
- déposer galvaniquement du nickel ou du cuivre dans la partie ouverte du moule jusqu'à la hauteur de celui-ci, et
- éliminer la couche sacrificielle et séparer de la plaquette support la structure métallique obtenue par électroformage, et enlever le moule en polyimide.

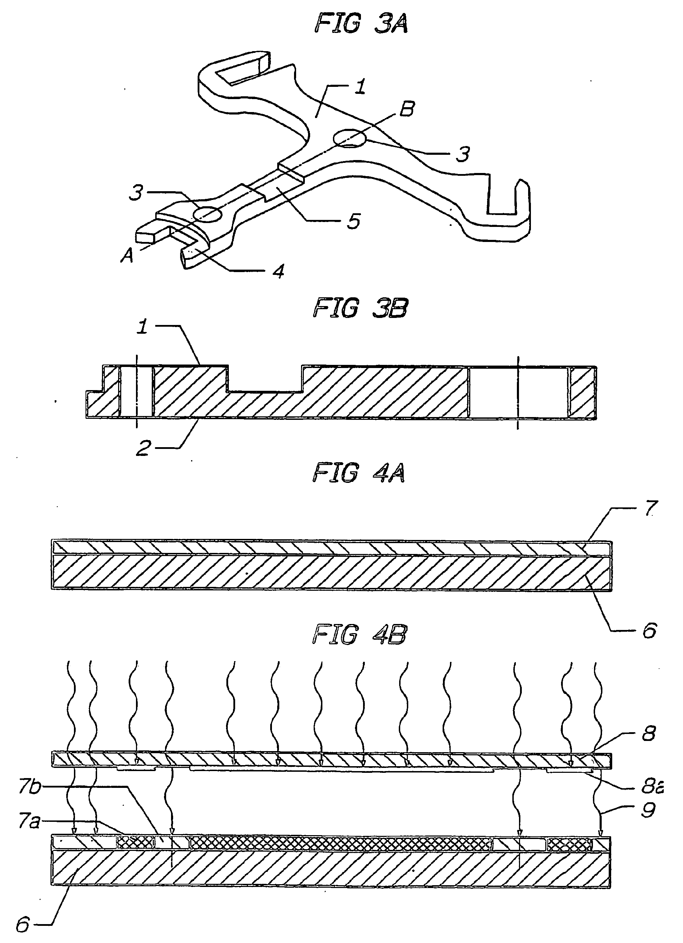

Ce document décrit la fabrication à l'aide de ce procédé de structures métalliques monocouches telles des engrenages en cuivre ou en nickel (cf. A) et B) pp. 89-91 et Figs. 3-7).

Frazier et al. divulgue aussi un procédé de fabrication de structures métalliques bicouches comportant les étapes suivantes :
- créer sur une plaquette support en silicium une couche métallique sacrificielle et une couche d'ensemencement pour l'électrodéposition,
- étaler par dépôt à la tournette (spin-coating) une couche de polyimide photosensible,
- effectuer à travers un masque correspondant à l'empreinte désirée une illumination aux rayons ultraviolets,
- développer en dissolvant les parties non irradiées de façon à obtenir un moule en polyimide,
- déposer galvaniquement du nickel dans la partie ouverte du moule jusqu'à hauteur de celui-ci de façon à obtenir une surface supérieure sensiblement plane,
- déposer par vaporisation sous vide une couche fine de chrome,
- déposer sur cette couche fine de chrome une couche de polyimide photosensible par dépôt à la tournette (spin-coating), et enlever la couche fine de chrome avec une solution d'acide chlorhydrique,
- effectuer une illumination UV à travers un nouveau masque correspondant à l'empreinte désirée, développer en dissolvant les parties non irradiées de façon à obtenir un nouveau moule en polyimide, et déposer galvaniquement du nickel dans la partie ouverte du moule, et
- éliminer la couche sacrificielle, séparer la structure métallique obtenue par électrodéposition de la plaquette support et éliminer le moule en polyimide.

Ce document décrit l'utilisation de ce procédé pour fabriquer une plaque métallique surmontée d'une protubérance de forme générale parallélépipédique (V. et Fig.9 page 92), la deuxième couche étant entièrement superposée sur la première couche de surface plus grande.

Les procédés décrits par Frazier et al. ne permettent pas d'effectuer d'opération d'usinage des structures fabriquées avant que celles-ci ne soient détachées de la plaquette-support en silicium. En effet celle-ci est trop fragile pour résister aux efforts mécaniques générés par un usinage. Si une opération d'usinage est nécessaire, elle nécessite le positionnement précis et l'immobilisation de chaque structure métallique fabriquée, ce qui rend la fabrication compliquée et difficile à mettre en oeuvre.

EP0851295 divulgue un autre procédé de fabrication par LIGA-UV de structures métalliques multicouches, telles qu'une roue dentée surmontée d'un pignon bicouche (Exemple 1) ou un microcapteur de flux thermique tricouche (Exemple 3). Ce procédé est proche de celui décrit par Frazier et al. et présente aussi les inconvénients exposés ci-dessus.

On a déjà proposé dans le US 5,766,441 de fabriquer une plaque métallique formée de trois couches formées par électroformage et procédé photo lithographique et munie d'un orifice d'entrée, d'un orifice de sortie, reliés par un conduit. Cette plaque métallique est formée sur un substrat en métal (cuivre) en silicium, en verre ou en céramique. La plaque ainsi formée est ensuite détachée du substrat. Le substrat n'est utilisé que pour effectuer le dépôt et les plaques formées sont détachées après que le dépôt des couches a été effectué.

On a encore proposé dans le US 2005/0056074 et dans le US 2003/0062652 la fabrication d'inserts de micro moules en formant sur un substrat en nickel, acier inoxydable, titane, silicium notamment, des micro plots à rapport de longueur élevé par le procédé LIGA. Le substrat métallique fait partie intégrante de l'insert et ne joue donc pas le rôle de support de travail pour la fabrication de pièces détachées du substrat une fois le procédé LIGA terminé.

Si l'usinage mécanique de pièces réalisées par LIGA sur un substrat en silicium n'est pas possible en raison de sa fragilité, le US 5,766,441 ne prévoit aucune utilisation du substrat en cuivre en tant que support d'usinage, quant au US 2005/0056074 et au US 2003/0062652, les éléments formés sur le substrat métallique ne sont pas détachés du substrat qui ne constitue pas un support de travail mais un élément intégré à la structure formée. Aucune opération d'usinage n'est par ailleurs réalisée sur les éléments que l'on a fait croître sur le substrat.

Le problème ou but de l'invention est de trouver un procédé de fabrication d'une structure métallique qui ne présente pas ces inconvénients.

Ce problème est résolu par l'invention telle que définie par les revendications.

La Demanderesse a en effet découvert que l'utilisation d'un substrat métallique massif à la place d'une plaquette support en silicium couverte d'une couche métallique sacrificielle et d'une couche d'ensemencement, permet d'usiner in situ la structure à l'issue de l'étape d'électroformage avant le détachage du substrat. On peut ainsi lors de la fabrication d'un grand nombre de structures (ou pièces) sur un même substrat usiner collectivement ces structures précisément positionnées et immobilisées sur celui-ci. L'étape supplémentaire de positionnement et d'immobilisation de chaque structure après détachage du substrat en vue d'un usinage ultérieur n'est donc plus nécessaire.

De plus, dans le cas de la fabrication de structures métalliques multicouches, l'utilisation d'un support métallique massif permet une mise à niveau par usinage (abrasion et polissage) à la fin de chaque étape d'électrodéposition de façon à obtenir une surface supérieure plane. Ceci a pour effet d'améliorer la qualité de la structure métallique multicouche obtenue car le dépôt électrolytique ultérieur s'effectue de façon plus régulière sur une surface polie que sur une surface présentant des irrégularités.

L'invention concerne ainsi un procédé de fabrication par une technologie de type LIGA d'une structure métallique monocouche ou multicouche, comme définie dans la revendication 1. L'irradiation dans un tel procédé de type LIGA peut être une irradiation aux rayons X ou une irradiation aux rayons UV, par illumination en mode normal à travers un masque, par illumination en mode laser pour créer un réseau de zones polymérisées ou par ablation par laser.

De préférence la technologie de type LIGA est une technologie de type LIGA-UV, c'est à dire une technologie de type LIGA utilisant une irradiation aux rayons UV.

Selon une forme préférée d'exécution, l'invention concerne un procédé de fabrication par une technologie de type LIGA-UV d'une structure métallique usinée monocouche, qui comprend les étapes définies dans la revendication 2.

Le substrat métallique massif est une plaquette métallique massive d'épaisseur en général de 1 à 5 mm, de forme quelconque par exemple cylindrique ou parallélépipédique, dont l'étendue de la surface supérieure est choisie en fonction du nombre de structures fabriquées sur un même substrat, en général de 10 à 3000, en particulier de 50 à 1000. Cette plaquette est formée d'un métal et/ou d'un alliage conducteur apte à ensemencer (démarrer) la réaction d'électroformage en jouant le rôle de cathode. Il est constitué d'acier inoxydable.

La surface supérieure du substrat métallique massif, destinée à être en contact avec le bain électrolytique, peut être polie ou texturée par exemple par microbillage, gravage chimique, mécanique ou par laser.

Le substrat métallique massif est dégraissé et préparé pour l'électroformage par un traitement approprié. Pour ce substrat constitué d'acier inox, un traitement approprié consiste par exemple à opérer un dégraissage en milieu alcalin, suivi par une neutralisation en milieu acide pour passiver sa surface, rincer à l'eau distillée et sécher.

Le photorésist est soit un photorésist négatif, à base d'une résine susceptible de polymériser sous l'action du rayonnement UV en présence d'un photoinitiateur, soit un photorésist positif, à base d'une résine susceptible de se décomposer sous l'action du rayonnement UV en présence d'un photoinitiateur. Le photorésist négatif est par exemple à base d'une résine époxy, d'une résine isocyanate ou d'une résine acrylique. Une résine époxy avantageuse est la résine époxy octofonctionelle SU-8 (Shell Chemical). Elle est utilisée en général en présence d'un photoinitiateur choisi parmi les sels de triarylsulfonium, par exemples ceux décrits dans les brevets US 4,058,401 et 4,882,245. Le photorésist positif est par exemple à base d'une résine phénolformaldéhydique de type novalaque en présence d'un photoinitiateur DNQ (DiazoNaphtoQuinone).

L'étalement du photorésist peut se faire par dépôt à la tournette (« spin-coating ») ou par une autre technique, telle que par exemple le trempage (« dip coating »), l'application au cylindre (« roller coating »), l'enduction par extrusion-laminage (« extrusion coating »), le revêtement par pulvérisation (« spray coating ») ou encore le laminage (pour les films secs, par exemple à base de résine acrylique). La technique d'étalement préférée est le dépôt à la tournette.

L'épaisseur maximale de photorésist pour induire l'effet recherché (photopolymérisation ou photodécomposition) dans les conditions d'irradiation de l'étape c) est de l'ordre de 1 mm. L'épaisseur maximale de la couche de photorésist qu'on peut étaler en une fois est de l'ordre de 150 µm selon la technique de dépôt à la tournette. Selon l'épaisseur souhaitée du photorésist, on étalera celui-ci sur le substrat métallique massif en une ou plusieurs fois.

Les conditions de chauffage éventuel du photorésist pour éliminer le solvant dans l'étape b) sont choisies en fonction de la nature et de l'épaisseur du photorésist selon les indications de son fabricant. Pour un photorésist à base d'une résine époxy SU-8 et d'épaisseur 140 µm, l'étape b) consiste par exemple à chauffer à 65 °C pendant 5 à 10 minutes, puis à 95 °C pendant une durée de 30 à 60 minutes. Pour un photorésist à base de film sec acrylique, cette étape de chauffage pour évaporer le solvant n'est pas nécessaire.

Dans le cas où il est nécessaire d'étaler le photorésist en plusieurs fois et de chauffer le photorésist pour évaporer le solvant, on effectuera l'étape b) à l'issue de l'étape a) après le premier étalement du photorésist et on reproduira les étapes a) et b) le nombre de fois nécessaire.

L'étape c) consiste à exposer la couche de photorésist à travers un masque correspondant à l'empreinte désirée à une irradiation UV de 100 à 2000 mJ/cm² mesurée à une longueur d'onde de 365 nm. Cette irradiation induit la photopolymérisation de la résine (photorésist négatif) ou la photodécomposition de celle-ci (photorésist positif).

L'étape d) consiste à effectuer, si nécessaire pour compléter la photopolymérisation ou la photodécomposition de l'étape c), un recuit de la couche obtenue à l'issue de c).

L'étape e) consiste à procéder au développement par dissolution des parties non irradiées (photorésist négatif) ou des parties irradiées (photorésist positif) à l'aide d'une solution aqueuse appropriée ou d'un solvant, choisi en fonction de la nature du photorésist selon les indications de son fabricant. Des exemples de solutions aqueuses appropriées sont des solutions alcalines de base faible, par exemple de carbonate de sodium, et des exemples de solvants appropriés sont le GBL (gammabutyrolactone), le PGMEA (propylène glycole méthyle éthyle acétate), et l'isopropanol. On utilise avantageusement comme solvant ou solution de développement, du PGMEA pour une résine époxy, et une solution de carbonate de sodium 1 % ou de l'isopropanol pour une résine acrylique.

L'étape f) consiste à déposer galvaniquement un métal ou un alliage dans les parties ouvertes du moule de photorésist, jusqu'à une hauteur déterminée inférieure ou égale à la hauteur du moule de photorésist en utilisant le substrat métallique massif comme cathode, et à mettre à niveau par usinage de façon à avoir une surface supérieure plane.

On utilise fréquemment comme métal pour l'électroformage le nickel, le cuivre, l'or ou l'argent, et comme alliage l'or-cuivre, le nickel-cobalt, le nickel-fer et le nickel-phosphore. Les conditions d'électroformage, notamment la composition des bains, la géométrie du système, les tensions et densités de courant, sont choisis pour chaque métal ou alliage à électrodéposer selon les techniques bien connues dans l'art de l'électroformage (cf. par exemple Di Bari G.A. "electroforming" Electroplating Engineering Handbook 4th Edition rédigée par L.J. Durney, publié par Van Nostrand Reinhold Compagny Inc., N.Y. USA 1984).

La mise à niveau par usinage se fait en général par abrasion et polissage, ce qui permet d'obtenir une surface supérieure plane avec des irrégularités de surface ne dépassant pas 1 µm environ.

L'étape g) consiste à effectuer, si nécessaire pour obtenir la structure souhaitée, d'autres opérations d'usinage sur la face supérieure de la structure métallique électroformée, telles que par exemple anglage, gravage ou usinage de décoration.

L'étape h) consiste à détacher par délaminage la structure métallique usinée du substrat métallique massif, et séparer le photorésist de la structure métallique usinée. Avant de séparer le photorésist on peut le cas échéant effectuer des opérations de gravage, traitement de surfaces, marquage mécanique ou par laser sur la structure métallique détachée.

La face inférieure de la structure métallique détachée par délaminage de la face supérieure du substrat métallique massif reproduit l'état de surface de cette face supérieure. Elle sera ainsi soit texturée (si la face supérieure du substrat métallique est texturée, par exemple par gravage ou microbillage) soit d'aspect poli (si la face supérieure du substrat métallique a subi un polissage). Dans ce dernier cas, à l'observation à l'oeil nu, l'aspect poli de la surface de la face inférieure de la structure ne se distingue pas de l'aspect poli obtenu le cas échéant par polissage sur la surface de la face supérieure. Par observation au microscope optique avec un grossissement de 50 fois, un éclairage adapté et une certaine orientation, ou au miscroscope électronique à balayage, ou à l'aide de systèmes topographiques d'analyse de surface, on parvient toutefois à distinguer ces deux surfaces.

La séparation ou le stripage du photorésist polymérisé de la structure mécanique usinée, se fait en général par attaque chimique ou traitement plasmatique. On libère ainsi la structure métallique usinée.

Le procédé de l'invention de fabrication d'une structure métallique monocouche sur un substrat métallique massif présente de nombreux avantages par rapport aux procédés connus de fabrication de telles structures sur une plaquette support en silicium.

Il permet en effet tout d'abord d'effectuer n'importe quelle opération d'usinage sur la surface supérieure de la structure obtenue après électroformage avant le détachage du substrat et la séparation du moule de photorésist polymérisé, notamment sa mise à niveau par abrasion et éventuellement polissage de façon à obtenir une surface plane, et une ou plusieurs autres opérations d'usinage telles que par exemple anglage, gravage ou usinage de décoration. On peut ainsi lors de la fabrication d'un grand nombre de structures (ou pièces) sur un même substrat usiner collectivement ces structures positionnées et immobilisées sur celui-ci, en bénéficiant pour cet usinage du positionnement et de l'immobilisation sur moules de photorésist polymérisé extrêmement précis, mis en oeuvre lors de l'exécution de la technique LIGA-UV. Il est très difficile d'obtenir une telle précision dans le positionnement et l'immobilisation de chaque structure métallique, lorsque celle-ci est détachée du substrat.

Le procédé de l'invention permet la fabrication de structures métalliques monocouches comportant un objet inséré avec un positionnement précis de celui-ci.

On peut en effet après avoir effectué les étapes a) à e), placer un objet fixé de façon amovible au dessus du substrat métallique massif et, lors du détachage par délaminage de la structure métallique du substrat métallique massif, libérer cet objet du substrat métallique massif. L'objet peut être par exemple une pierre telle qu'un rubis. Le fait d'utiliser un substrat métallique massif permet de positionner précisément cet objet de façon rigoureuse et de le fixer de façon amovible au dessus de ce substrat, à une faible distance de sa surface, par exemple à l'aide de pivots ou de goupilles. Lors de l'étape f), le métal ou l'alliage électroformé va entourer et insérer cet objet. On obtient ainsi, en libérant lors de l'étape h) cet objet du substrat métallique massif, une structure monocouche comportant un objet inséré (un "insert").

Le positionnement précis et la fixation amovible d'un objet n'est pas possible au dessus d'une plaquette support en silicium couverte d'une couche métallique sacrificielle et d'une couche d'ensemencement. Les procédés connus de fabrication de structures métalliques monocouches par LIGA-UV utilisent une telle plaquette et ne permettent donc pas d'insérer un objet dans la structure métallique.

L'invention concerne donc aussi une nouvelle structure métallique usinée monocouche comportant un objet inséré, susceptible d'être obtenue par le procédé défini ci-dessus.

Le procédé de l'invention permet également la fabrication de structures métalliques monocouches comportant un trou fileté positionné de façon précise.

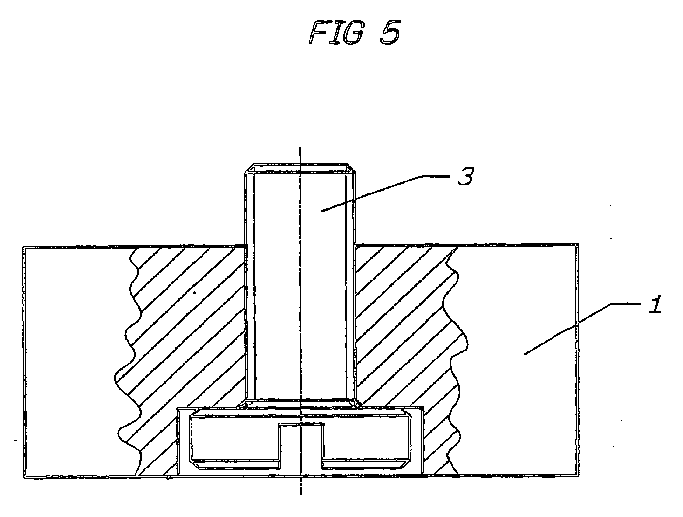

On peut en effet après avoir effectué les étapes a) à e), placer une vis 3 dans un trou taraudé sur le substrat métallique massif 1 laquelle dépasse au dessus de la surface supérieure de celui-ci (cf. Figure 5) et, lors du détachage par délaminage de la structure métallique, dévisser cette vis du substrat métallique massif. La vis est constituée d'une matière inerte n'accrochant pas au métal électroformé, par exemple de Teflon® (PTFE). En dessous de l'endroit où l'on veut positionner le trou fileté, on taraude dans le substrat métallique massif 1 un trou fileté le traversant verticalement et on introduit dans ce dernier par dessous (cf. Figure 5) une vis 3 dont une partie dépasse au dessus du substrat. Lors de l'étape f), le métal ou l'alliage va entourer la partie de la vis qui dépasse du substrat métallique massif. Lors de l'étape h), on dévisse cette vis du substrat métallique massif, de façon à obtenir un trou fileté dans la structure métallique monocouche détachée.

Il n'est pas possible de tarauder dans une plaquette support en silicium car celle-ci est trop fragile et se casse. Les procédés connus de fabrication de structures métalliques monocouches par LIGA-UV utilisent une telle plaquette : ils ne permettent donc pas de fabriquer une structure comportant un trou fileté.

L'invention concerne donc aussi une nouvelle structure métallique usinée monocouche comportant un trou fileté, susceptible d'être obtenue par le procédé défini ci-dessus.

L'invention concerne aussi un procédé de fabrication par une technologie de type LIGA-UV d'une structure métallique usinée multicouche à couches entièrement superposées, qui comprend les étapes définies dans la revendication 3.

L'expression "multicouche à couches entièrement superposées" signifie que pour deux couches adjacentes le contour de la couche supérieure rentre entièrement dans l'élévation verticale du contour de la couche inférieure.

Les étapes a), b), c), d), e) et f) sont les mêmes que celles du procédé décrit ci-dessus de fabrication par LIGA-UV d'une structure métallique monocouche.

L'étape g) consiste à reproduire les étapes a), b), c), d), et e), et activer la surface du métal électroformé non recouverte de photorésist polymérisé par traitement électrochimique.

On reproduit les étapes a), b), c), d), et e) en utilisant dans l'étape a) comme substrat la surface supérieure plane obtenue à l'issue de l'étape f), et dans l'étape c) un nouveau masque correspondant à l'empreinte désirée pour la nouvelle couche de métal électroformée.

L'activation de la surface du métal électroformé non recouverte de photorésist polymérisé à l'issue de la reproduction de l'étape e) se fait par application d'un courant inverse en faisant jouer au métal électroformé le rôle d'anode selon les techniques bien connues dans l'art du traitement des surfaces.

L'étape h) consiste à reproduire l'étape f) : on dépose galvaniquement un métal ou un alliage dans la partie ouverte du nouveau moule en photorésist polymérisé obtenu à l'issue de la reproduction de l'étape e), et on met à niveau par usinage, en général par abrasion et polissage, de façon à obtenir une surface supérieure plane (avec des irrégularités de surface en général ne dépassant pas 1 µm environ). Le métal ou l'alliage déposé galvaniquement au cours de l'étape h) peut être identique au, ou différent du, métal ou alliage déposé galvaniquement au cours de l'étape f). En général il s'agit du même métal ou alliage.

L'étape i) consiste à reproduire les étapes g) et h), si nécessaire pour obtenir la structure métallique multicouche souhaitée. Cette reproduction n'est pas nécessaire dans le cas de la fabrication d'une structure métallique bicouche.

L'étape j) consiste à effectuer, si nécessaire pour obtenir la structure souhaitée, d'autres opérations d'usinage sur la face supérieure de la structure mécanique électroformée, telles que par exemple anglage, gravage ou usinage de décoration.

L'étape k) consiste à détacher par délaminage la structure métallique usinée du substrat métallique massif, et séparer le photorésist de la structure mécanique usinée.

La face inférieure de la structure métallique détachée de la face supérieure du substrat métallique massif reproduit l'état de surface de celle-ci. Elle sera ainsi soit texturée (si la face supérieure du substrat métallique est texturée, par exemple par gravage ou microbillage) soit d'aspect poli (si la face supérieure du substrat métallique a subi un polissage). Dans ce dernier cas, à l'observation à l'oeil nu, l'aspect poli de la surface de la face inférieure de la structure ne se distingue pas de l'aspect poli obtenu le cas échéant par polissage sur la surface de la face supérieure. Par observation au microscope optique avec un grossissement de 50 fois, un éclairage adapté et une certaine orientation, ou au miscroscope électronique à balayage, ou à l'aide de systèmes topographiques d'analyse de surface, on parvient toutefois à distinguer ces deux surfaces.

La séparation ou le stripage du photorésist polymérisé de la structure mécanique usinée, s'effectue en général par attaque chimique ou traitement plasmatique. On libère ainsi la structure métallique usinée.

Le procédé de l'invention de fabrication d'une structure métallique multicouche à couches entièrement superposées sur un substrat métallique massif présente de nombreux avantages par rapport aux procédés connus de fabrication de telles structures sur une plaquette support en silicium.

IL permet d'effectuer n'importe quelle opération d'usinage sur la surface supérieure de la structure métallique obtenue après l'étape finale d'électroformage, avant le détachage du substrat, notamment un anglage, un gravage ou un usinage de décoration. On peut ainsi lors de la fabrication d'un grand nombre de structures (ou pièces) sur un même substrat usiner collectivement ces structures positionnées et immobilisées sur celui-ci, en bénéficiant pour cet usinage du positionnement et de l'immobilisation sur moules de photorésist polymérisé extrêmement précis, mis en oeuvre lors de l'exécution de la technique LIGA-UV. Il est très difficile d'obtenir une telle précision dans le positionnement et l'immobilisation de chaque structure métallique, lorsque celle-ci est détachée.

Le procédé de l'invention comprend une mise à niveau par usinage (abrasion et polissage) à la fin de chaque étape d'électrodéposition de façon à obtenir une surface supérieure plane. Ceci a pour effet d'améliorer la qualité de la structure métallique multicouche obtenue, notamment certaines propriétés mécaniques et/ou d'aspect, car le dépôt électrolytique ultérieur s'effectue de façon plus régulière sur une surface polie que sur une surface présentant des irrégularités.

On obtient ainsi une structure métallique usinée multicouche à couches entièrement superposées, nouvelle et à propriétés avantageuses.

L'invention concerne donc également la structure métallique usinée multicouche à couches entièrement superposées susceptible d'être obtenue par le procédé défini ci-dessus.

Le procédé de l'invention permet aussi, grâce à l'utilisation d'un substrat métallique massif, l'obtention de nouvelles structures métalliques multicouches à couches entièrement superposées comprenant un objet inséré ou un trou fileté dans la première couche électroformée, en procédant de façon analogue à ce qui est décrit ci-dessus pour les structures métalliques monocouches. De telles structures multicouches comprenant un objet inséré ou un trou fileté ne peuvent être obtenues par les procédés connus de fabrication par LIGA-UV de structures métalliques multicouches, qui utilisent une plaquette support en silicium.

L'invention concerne ainsi également une structure métallique usinée multicouche comportant dans sa première couche un objet inséré ou un trou fileté susceptible d'être obtenue par le procédé défini ci-dessus.

D'autres particularités et avantages de l'invention apparaîtront à la lecture de la description détaillée qui va suivre, en référence aux dessins annexés, qui illustrent schématiquement et à titre d'exemple, quelques formes d'exécution du procédé de l'invention.

Dans ces dessins:
- la Figure 1 est une vue en perspective d'un ressort de rappel à structure monocouche,
- les Figures 2A à 2F sont des vues en coupe selon la ligne AB de la Figure 1 représentant les différentes étapes de la fabrication du ressort de la Figure 1,
- la Figure 3A est une vue en perspective de dessous, et la Figure 3B est une vue en coupe selon la ligne AB de la Figure 3A, d'une ancre pour échappement de mouvement d'horlogerie,
- les Figures 4A à 4H sont des vues en coupe représentant schématiquement les différentes étapes de la fabrication de l'ancre des Figures 3A et 3B,
- la Figure 5 est une vue en coupe partielle d'un assemblage d'une vis dans un trou taraudé du substrat métallique massif, et dépassant au-dessus de la surface de celui-ci.

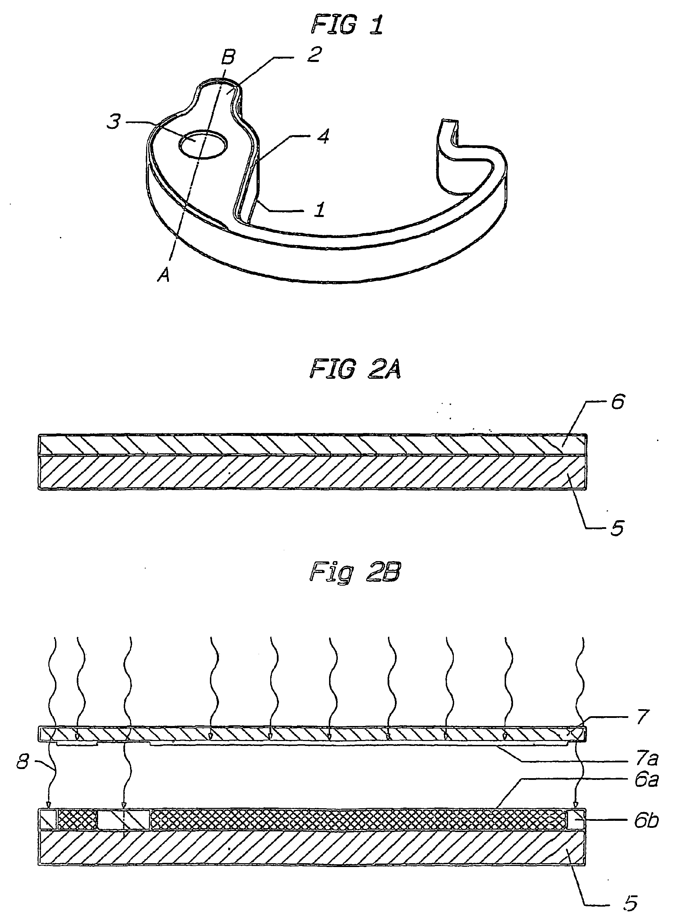

Les exemples ci-après décrivent la fabrication selon le procédé de l'invention de ce ressort de rappel et de cette ancre, en référence aux figures 1 à 4H.

### Exemple 1 : Fabrication d'un ressort de rappel

La Figure 1 représente un ressort de rappel avec un côté supérieur 2, un côté inférieur 1, un trou cylindrique 3 et une partie anglée 4. Les dimensions de ce ressort sont les suivantes : épaisseur 0,170 mm (± 7 µm), diamètre 0,412 mm (± 2 µm), largeur de lame 0,046 mm (± 2 µm) et encombrement de l'ordre de 2 mm X 3,5 mm.

A la Figure 2A on a représenté la structure obtenue à l'issue de l'étape b) du procédé de la revendication 2, qui comprend une couche de photorésist 6 recouvrant le substrat 5. Cette structure a été obtenue selon le protocole décrit ci-après.

Un substrat 5 formé d'une plaquette en acier inox de 1 mm d'épaisseur et de 150 mm de diamètre, a été dégraissé et préparé pour l'électroformage par dégraissage avec une solution alcaline, neutralisation avec une solution acide pour passiver sa surface, puis rinçage à l'eau distillée et séchage. On a ensuite procédé à l'étalement sur le substrat 5 par dépôt à la tournette d'une première couche de photorésist négatif à base de résine époxy octofonctionelle SU-8 de 100 µm d'épaisseur, puis au chauffage pour évaporation du solvant pendant 5 minutes à 65 °C, puis 20 minutes à 95°C. On a ensuite procédé à l'étalement sur la première couche de photorésist par dépôt à la tournette d'une deuxième couche du même photorésist de 100 µm d'épaisseur, puis au chauffage pour évaporation du solvant pendant 5 minutes à 65 °C, puis 45 minutes à 95°C.

La Figure 2B correspond à l'étape c) de la revendication 2, avec une illumination UV d'environ 500 mi/cm² centrée à 365 nm du photorésist à travers un masque correspondant à l'empreinte désirée. On distingue sur cette figure le masque comportant un support 7 transparent aux UV et des zones opaques 7a formées par des dépôts de chrome. Le même support formant le masque peut comporter un grand nombre de zones correspondant à autant de structures pouvant être fabriquées en un seul lot, toutes les zones étant obtenues avec une très haute résolution du contour par photolithographie, technique bien connue dans l'industrie microélectronique.

Cette irradiation par rayons UV 8 induit la photopolymérisation de la résine dans les zones exposées 6b, les zones non exposées 6a restant non polymérisées.

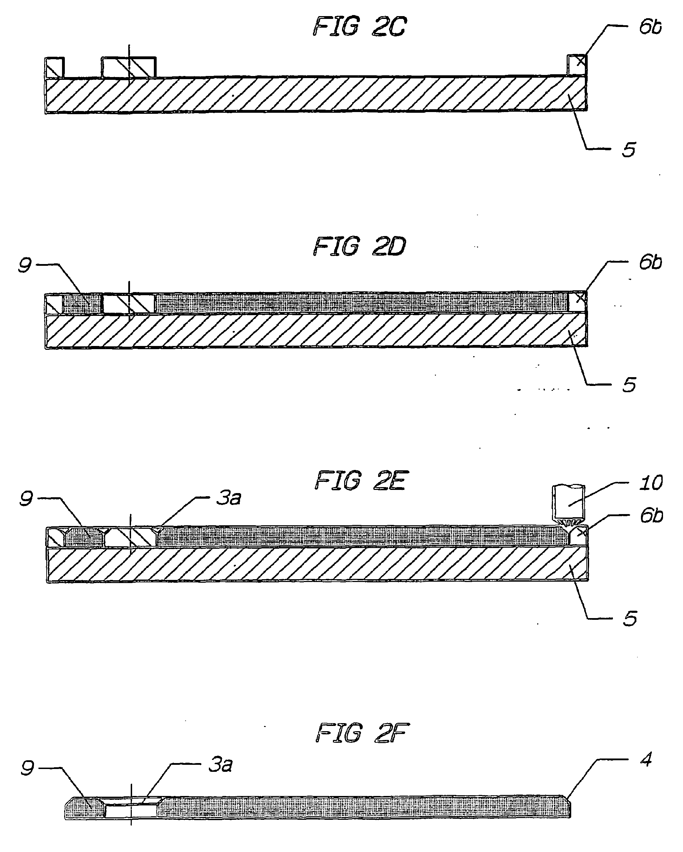

La Figure 2C montre la structure obtenue à l'issue de l'étape e) de la revendication 2. On a effectué un recuit de la couche obtenue à l'issue de l'étape c) pour compléter la polymérisation pendant 1 minute à 65 °C, puis 15 minutes à 95 °C, puis dissolution du photorésist non exposé par passage pendant 15 minutes dans trois bains successifs de PGMEA (de plus en plus pur), rinçage dans un bain d'alcool isopropylique et séchage. On distingue dans la Figure 2C le moule 6b en photorésist polymérisé superposé sur le substrat 5.

La Figure 2D montre la structure obtenue à l'issue de l'étape f) de la revendication 2 après dépôt galvanique de nickel, puis mise à niveau par abrasion et polissage de façon à obtenir une surface supérieure plane. On distingue sur cette figure le moule de résine polymérisée 6b et la couche électroformée 9, qui recouvrent le substrat 5.

La Figure 2E montre la structure obtenue au cours de l'étape g) de la revendication 2 pendant une opération d'anglage. On distingue sur cette figure le substrat 5, la structure métallique 9, le moule de résine polymérisée 6b, le trou anglé 3a et la fraise 10 utilisée pour l'anglage.

La Figure 2F, qui correspond à la vue en coupe de la Figure 1, montre le ressort obtenu à l'issue de l'étape h) de la revendication 2, après détachage du substrat métallique par délaminage et stripage du photorésist polymérisé avec le N-méthylpyrrolidone.

### Exemple 2: Fabrication d'une ancre d'échappement pour mouvement d'horlogerie

Les Figures 3A et 3B représentent une ancre comportant un côté supérieur 1, un côté inférieur 2, un trou cylindrique 3, une fourchette 4 et un dégagement 5. Les dimensions de cette ancre sont les suivantes : épaisseur du premier niveau 0,105 mm (± 5 µm), épaisseur du deuxième niveau 0,07 mm (± 5 µm), épaisseur totale 0,175 mm (± 10 µm), diamètre 0,306 mm (± 1 µm), diamètre selon AB 0,250 mm (± 4 µm), encombrement de l'ordre de 4 mm X 3 mm.

A la Figure 4A on a représenté la structure obtenue à l'issue de l'étape b) du procédé de la revendication 3, qui comprend une couche de photorésist 7 recouvrant le substrat 6. Cette structure a été obtenue selon le protocole décrit ci-après.

Un substrat 6 formé d'une plaquette en acier inox de 1 mm d'épaisseur et de 150 mm de diamètre, a été dégraissé et préparé pour l'électroformage par dégraissage avec une solution alcaline, neutralisation avec une solution acide pour passiver sa surface, puis rinçage à l'eau distillée et séchage. On a ensuite procédé à l'étalement sur le substrat 5 par dépôt à la tournette d'une première couche de photorésist négatif à base de résine époxy octofonctionelle SU-8 de 70 µm d'épaisseur, puis au chauffage pour évaporation du solvant pendant 3 minutes à 65 °C, puis 9 minutes à 95 °C. On a ensuite procédé à l'étalement sur la première couche de photorésist par dépôt à la tournette d'une deuxième couche du même photorésist de 70 µm d'épaisseur, puis au chauffage pour évaporation du solvant pendant 5 minutes à 65 °C, puis 35 minutes à 95°C.

La Figure 4B correspond à l'étape c) de la revendication 3 d'illumination UV d'environ 450 mJ/cm² centrée à 365 nm, du photorésist à travers un masque correspondant à l'empreinte désirée. On distingue sur cette figure le masque comportant un support 8 transparent aux UV et des zones opaques 8a formées par des dépôts de chrome. Cette irradiation par rayons UV 9 induit la photopolymérisation de la résine dans les zones exposées 7b, les zones non exposées 7a restant non polymérisées.

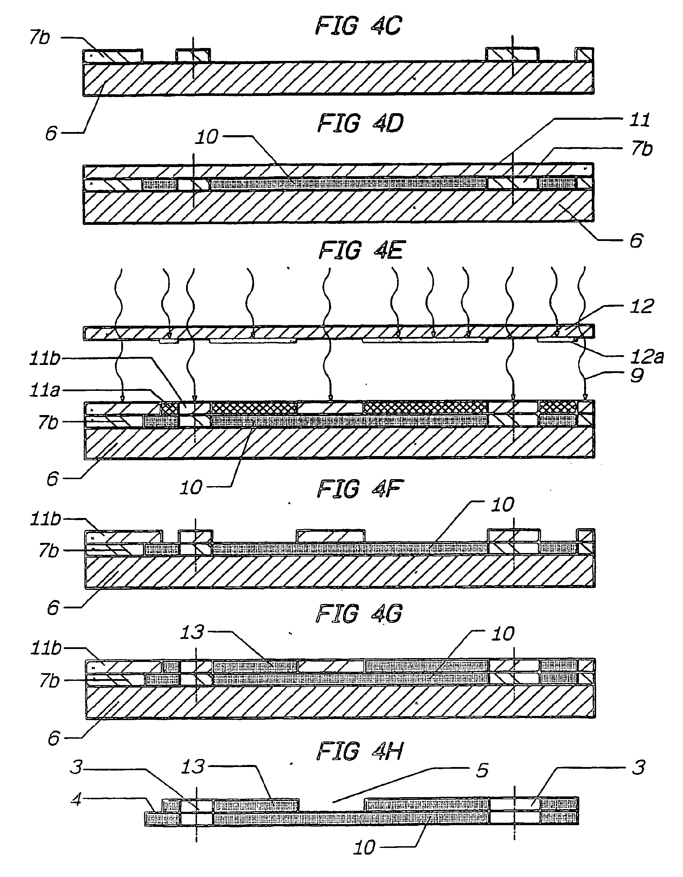

La Figure 4C montre la structure obtenue à l'issue de l'étape e) de la revendication 3. On a effectué un recuit de la couche obtenue à l'issue de l'étape c) pour compléter la polymérisation pendant 1 minute à 65 °C, puis 15 minutes à 95 °C, puis dissout le photorésist non exposé par passage de 15 minutes dans trois bains successifs de PGMEA (de plus en plus pur), rinçage dans un bain d'alcool isopropylique et séchage. On distingue dans cette figure le moule de photorésist polymérisé 7b sur le substrat 6.

La Figure 4D montre la structure obtenue après avoir effectué l'étape f) de la revendication 3 de dépôt galvanique de nickel dans les parties ouvertes du moule de photorésist polymérisé, et mise à niveau par abrasion et polissage de façon à obtenir une surface supérieure plane, et reproduit les étapes a) et b) avec deux couches successives de 50 µm du même photorésist à base de résine époxy SU-8, chauffage pendant 3 minutes à 65 °C puis 6 minutes à 95 °C pour la première couche, et chauffage pendant 5 minute à 65 °C puis 20 minutes à 95 °C pour la deuxième couche. On distingue sur la Figure 4D la couche de photorésist 11 recouvrant le photorésist polymérisé 7b et la couche électroformée 10, au-dessus du substrat 6.

La Figure 4E correspond à la reproduction de l'étape c) de la revendication 3 (au cours de l'étape g)), avec une illumination UV d'environ 400 mJ/cm² centrée à 365 nm, du photorésist à travers un nouveau masque correspondant à l'empreinte désirée. On distingue sur cette figure le masque comportant un support 12 transparent aux UV et des zones opaques 12a formées par des dépôts de chrome. Cette irradiation par rayons UV 9 induit la photopolymérisation de la résine dans les zones exposées 11b, les zones non exposées 11a restant non polymérisées.

La Figure 4F montre la structure obtenue à l'issue de la reproduction de l'étape e) de la revendication 3 (au cours de l'étape g)). On a effectué un recuit de la couche obtenue à l'issue de la reproduction de l'étape c) pour compléter la polymérisation pendant 1 minute à 65 °C, puis 15 minutes à 95 °C, puis dissous le photorésist non exposé par passage pendant 15 minutes dans trois bains successifs de PGMEA (de pureté croissante), rinçage dans un bain d'alcool isopropylique et séchage. On distingue dans cette figure le deuxième moule de photorésist polymérisé 11b au-dessus du premier moule de photorésist polymérisé 7b et la couche de métal électroformé 10, au-dessus du substrat 6.

La Figure 4G montre la structure obtenue à l'issue de la reproduction de l'étape f) de la revendication 3 (au cours de l'étape h)). On a effectué un deuxième dépôt galvanique du même métal, le nickel, jusqu'à une hauteur légèrement supérieure (de 10 à 30 µm) à l'épaisseur visée, puis mis à niveau par abrasion et polissage de façon à obtenir une surface supérieure plane. On distingue sur cette figure le deuxième moule de résine polymérisée 11b et la deuxième couche électroformée 13, au-dessus du premier moule polymérisé 7b et de la première couche électroformée 10, au-dessus du substrat 6.

La Figure 4H, qui correspond à la vue en coupe de la Figure 3B, montre l'ancre obtenue à l'issue de l'étape k) de la revendication 3, après détachage du substrat métallique par délaminage et élimination du photorésist polymérisé par un traitement plasmatique.

## Revendications

1. Procédé de fabrication par une technologie de type LIGA d'une pluralité de structures métalliques monocouches ou multicouches, dans lequel on étale une couche de photorésist sur un support métallique massif constitué d'acier inoxydable, on crée par irradiation ou bombardement électronique ou ionique un moule de photorésist, on dépose galvaniquement un métal ou un alliage dans ce moule, on usine mécaniquement cette structure métallique, on sépare ladite structure et le photorésist du support métallique massif et on élimine le photorésist, **caractérisé en ce qu'**on passive la surface dudit support pour séparer la structure métallique et le photorésist du support métallique massif par délaminage.

2. Procédé selon la revendication 1 de fabrication par une technologie de type LIGA-UV d'une pluralité de structures métalliques usinées monocouches, qui comprend les étapes suivantes:
a) étaler une couche de photorésist sur un support métallique massif,
b) chauffer la couche de photorésist, si nécessaire pour évaporer le solvant,
c) exposer la couche de photorésist à travers un masque correspondant à l'empreinte désirée à une irradiation UV de 100 à 2000 mJ/cm² mesurée à une longueur d'onde de 365 nm,
d) effectuer, si nécessaire pour compléter la photopolymérisation ou la photodécomposition, un recuit de la couche obtenue à l'issue de l'étape c),
e) procéder au développement par dissolution des parties non polymérisées ou photodécomposées,
f) déposer galvaniquement un métal ou un alliage dans les parties ouvertes du moule de photorésist, et mettre à niveau par usinage de façon à obtenir une surface supérieure plane,
g) effectuer, si nécessaire, une ou plusieurs autres opérations d'usinage sur la face supérieure des structures métalliques électroformées et
h) détacher par délaminage les structures métalliques et le photorésist polymérisé du support métallique massif, et séparer le photorésist polymérisé des structures métalliques monocouches usinées.

3. Procédé selon la revendication 1 de fabrication par une technologie de type LIGA-UV d'une pluralité de structures métalliques usinées multicouches à couches entièrement superposées, qui comprend les étapes suivantes:
a) étaler une couche de photorésist sur un support métallique massif,
b) chauffer la couche de photorésist, si nécessaire pour évaporer le solvant,
c) exposer la couche de photorésist à travers un masque correspondant à l'empreinte désirée à une irradiation UV de 100 à 2000 mJ/cm² mesurée à une longueur d'onde de 365 nm,
d) effectuer, si nécessaire pour compléter la photopolymérisation ou la photodécomposition, un recuit de la couche obtenue à l'issue de l'étape c),
e) procéder au développement par dissolution des parties non polymérisées ou photodécomposées,
f) déposer galvaniquement un métal ou un alliage dans les parties ouvertes du moule de photorésist, et mettre à niveau par usinage de façon à obtenir une surface supérieure plane,
g) reproduire les étapes a), b), c), d), e) et activer par traitement électrochimique la surface du métal électroformé non recouverte de photorésist polymérisé,
h) reproduire l'étape f),
i) reproduire, si nécessaire, les étapes g) et h),
j) effectuer, si nécessaire, une ou plusieurs autres opérations d'usinage sur la face supérieure des structures métalliques électroformées, et
k) détacher par délaminage les structures métalliques et le photorésist polymérisé du support métallique massif, et séparer le photorésist polymérisé des structures métalliques usinées multicouches à couches superposées.

4. Procédé selon l'une des revendications précédentes, selon lequel après avoir détaché les structures métalliques par délaminage du support métallique massif et avant de séparer le photorésist, on effectue sur les structures métalliques une ou plusieurs opérations de gravage, de traitement de surface, de marquage mécanique ou par laser.

5. Procédé selon l'une des revendications précédentes **caractérisé en ce que** le support métallique massif a une surface supérieure texturée, par microbillage, gravage chimique, mécanique ou par laser.

6. Procédé selon l'une des revendications précédentes **caractérisé en ce que** le support métallique massif a une surface supérieure polie.

7. Procédé selon l'une des revendications 2 à 6 **caractérisé en ce qu'**après les étapes a) à e) on place des
objets fixés de façon amovible sur le support métallique massif, et que lors du détachage par délaminage des structures métalliques et du photorésist polymérisé du support métallique massif, on libère ces objets du support métallique massif, de façon à obtenir des structures métalliques monocouches ou multicouches à couches entièrement superposées comportant un objet inséré.

8. Procédé selon l'une des revendications 2 à 6 **caractérisé en ce qu'**après les étapes a) à e) on place des vis dans des trous taraudés du support métallique massif, lesquelles dépassent au-dessus de la surface supérieure de celui-ci, et que lors du détachage par délaminage des structures métalliques et du photorésist polymérisé du support métallique massif, on devisse ces vis, de façon à obtenir des structures métalliques monocouches ou multicouches à couches entièrement superposées comportant un trou fileté.

9. Structure métallique usinée monocouche de mouvement d'horlogerie obtenue selon l'une des revendications 7 et 8 dépendantes de la revendication 2.

10. Structure métallique usinée monocouche ou multicouche à couches entièrement superposées dans laquelle un insert est incorporé, par le procédé selon la revendication 7.

11. Structure métallique usinée monocouche ou multicouche à couches entièrement superposées comportant un trou fileté formé par le procédé selon la revendication 8.

12. Procédé de fabrication par une technologie de type LIGA d'une structure métallique monocouche ou multicouche à couches entièrement superposées, qui comprend les étapes suivantes :
a) étaler une couche de photorésist sur un substrat métallique massif,
b) chauffer la couche de photorésist, si nécessaire pour évaporer le solvant,
c) exposer la couche de photorésist à travers un masque correspondant à l'empreinte désirée à une irradiation UV de 100 à 2000 mJ/cm² mesurée à une longueur d'onde de 365 nm,
d) effectuer, si nécessaire pour compléter la photopolymérisation ou la photodécomposition, un recuit de la couche obtenue à l'issue de l'étape c),
e) procéder au développement par dissolution des parties non polymérisées ou photodécomposées,
f) déposer galvaniquement un métal ou un alliage dans les parties ouvertes du moule de photorésist, et mettre à niveau par usinage de façon à obtenir une surface supérieure plane,
puis
g) dans le cas d'une structure monocouche, effectuer, si nécessaire, une ou plusieurs autres opérations d'usinage sur la face supérieure de la structure mécanique électroformée, et
h) détacher par délaminage la structure métallique et le photorésist polymérisé du substrat métallique massif, et séparer le photorésist polymérisé de la structure métallique monocouche usinée ;
ou
g) dans le cas d'une structure multicouche à couches superposées, reproduire les étapes a), b), c), d), e) et activer par traitement électrochimique la surface du métal électroformé non recouverte de photorésist polymérisé,
h) reproduire l'étape f),
i) reproduire, si nécessaire, les étapes g) et h) ,
j) effectuer, si nécessaire, une ou plusieurs autres opérations d'usinage sur la face supérieure de la structure mécanique électroformée, et
k) détacher par délaminage la structure métallique et le photorésist polymérisé du substrat métallique massif, et séparer le photorésist polymérisé de la structure métallique usinée multicouche à couches superposées,
**caractérisé en ce qu'**après les étapes a) à e) on place un objet fixé de façon amovible au-dessus du substrat métallique massif, et que lors du détachage par délaminage de la structure métallique et du photorésist polymérisé du substrat métallique massif, on libère cet objet du substrat métallique massif, de façon à obtenir une structure métallique monocouche ou multicouche à couches entièrement superposées comportant un objet inséré.

13. Procédé de fabrication par une technologie de type LIGA d'une structure métallique monocouche ou multicouche à couches entièrement superposées, qui comprend les étapes suivantes :
a) étaler une couche de photorésist sur un substrat métallique massif,
b) chauffer la couche de photorésist, si nécessaire pour évaporer le solvant,
c) exposer la couche de photorésist à travers un masque correspondant à l'empreinte désirée à une irradiation UV de 100 à 2000 mJ/cm² mesurée à une longueur d'onde de 365 nm,
d) effectuer, si nécessaire pour compléter la photopolymérisation ou la photodécomposition, un recuit de la couche obtenue à l'issue de l'étape c),
e) procéder au développement par dissolution des parties non polymérisées ou photodécomposées,
f) déposer galvaniquement un métal ou un alliage dans les parties ouvertes du moule de photorésist, et mettre à niveau par usinage de façon à obtenir une surface supérieure plane,
puis
g) dans le cas d'une structure monocouche, effectuer, si nécessaire, une ou plusieurs autres opérations d'usinage sur la face supérieure de la structure mécanique électroformée, et
h) détacher par délaminage la structure métallique et le photorésist polymérisé du substrat métallique massif, et séparer le photorésist polymérisé de la structure métallique monocouche usinée ;
ou
g) dans le cas d'une structure multicouche à couches superposées, reproduire les étapes a), b), c), d), e) et activer par traitement électrochimique la surface du métal électroformé non recouverte de photorésist polymérisé,
h) reproduire l'étape f),
i) reproduire, si nécessaire, les étapes g) et h),
j) effectuer, si nécessaire, une ou plusieurs autres opérations d'usinage sur la face supérieure de la structure mécanique électroformée, et
k) détacher par délaminage la structure métallique et le photorésist polymérisé du substrat métallique massif, et séparer le photorésist polymérisé de la structure métallique usinée multicouche à couches superposées,
**caractérisé en ce qu'**après les étapes a) à e) on place une vis dans un trou taraudé du substrat métallique massif laquelle dépasse au-dessus de la surface supérieure de celui-ci, et que lors du détachage par délaminage de la structure métallique et du photorésist polymérisé du substrat métallique massif, on devisse cette vis, de façon à obtenir une structure métallique monocouche ou multicouche à couches entièrement superposées comportant un trou fileté.

14. Structure métallique usinée monocouche obtenue selon la revendication 12 ou 13, **caractérisée en ce qu'**elle est une pièce de mouvement d'horlogerie, en particulier un ressort.

15. Structure métallique usinée monocouche ou multicouche à couches entièrement superposées comportant un objet inséré, **caractérisée en ce qu'**elle est susceptible d'être obtenue par un procédé selon la revendication 12.

16. Structure métallique usinée monocouche ou multicouche à couches entièrement superposées comportant un trou fileté, **caractérisée en ce qu'**elle est susceptible d'être obtenue par un procédé selon la revendication 13.

17. Structure métallique usinée multicouche à couches entièrement superposées obtenue par un procédé selon la revendication 12 ou 13, **caractérisée en ce qu'**elle est une ancre d'échappement pour mouvement d'horlogerie.

## Claims

1. Process for fabricating a plurality of monolayer or multilayer metallic structures by a LIGA type technology, in which a layer of photoresist is spread over a solid metallic support consisting of stainless steel, a photoresist mould is created by irradiation or electron or ion bombardment, a metal or an alloy is electrolytically deposited in this mould, this metallic structure is mechanically machined, the said structure and the photoresist are separated from the solid metallic support and the photoresist is removed, **characterised in that** the surface of the said support is passivated in order to separate the metallic structure and the photoresist from the solid metallic support by delamination.

2. Process according to Claim 1 for fabricating a plurality of machined monolayer metallic structures by a UV-LIGA type technology, which comprises the following steps:
a) spreading a layer of photoresist over a solid metallic support,
b) heating the layer of photoresist, if necessary, in order to evaporate the solvent,
c) exposing the layer of photoresist through a mask corresponding to the desired impression with 100 to 2000 mJ/cm² of UV radiation measured at a wavelength of 365 nm,
d) if necessary, in order to complete the photopolymerisation or photodecomposition, annealing the layer obtained after step c),
e) developing by dissolving the parts which have not been polymerised or photodecomposed,
f) electrolytically depositing a metal or an alloy in the open parts of the photoresist mould, and levelling by machining so as to obtain a plane upper surface,
g) if necessary, carrying out one or more other machining operations on the upper face of the electroformed metallic structures, and
h) detaching the metallic structures and the polymerised photoresist from the solid metallic support by delamination, and separating the polymerised photoresist from the machined monolayer metallic structures.

3. Process according to Claim 1 for fabricating a plurality of machined multilayer metallic structures with fully superimposed layers by a UV-LIGA type technology, which comprises the following steps:
a) spreading a layer of photoresist over a solid metallic support,
b) heating the layer of photoresist, if necessary, in order to evaporate the solvent,
c) exposing the layer of photoresist through a mask corresponding to the desired impression with 100 to 2000 mJ/cm² of UV radiation measured at a wavelength of 365 nm,
d) if necessary, in order to complete the photopolymerisation or photodecomposition, annealing the layer obtained after step c),
e) developing by dissolving the parts which have not been polymerised or photodecomposed,
f) electrolytically depositing a metal or an alloy in the open parts of the photoresist mould, and levelling by machining so as to obtain a plane upper surface,
g) repeating steps a), b), c), d), e) and activating by electrochemical treatment the surface of the electroformed metal not covered with polymerised photoresist,
h) repeating step f),
i) if necessary, repeating steps g) and h),
j) if necessary, carrying out one or more other machining operations on the upper face of the electroformed metallic structures, and
k) detaching the metallic structures and the polymerised photoresist from the solid metallic support by delamination, and separating the polymerised photoresist from the machined multilayer metallic structures with superimposed layers.

4. Process according to one of the preceding claims, according to which one or more etching, surface treatment, mechanical or laser marking operations are carried out on the metallic structures after having detached the metallic structures from the solid metallic support by delamination and before separating the photoresist.

5. Process according to one of the preceding claims, **characterised in that** the solid metallic support has an upper surface textured by microbeading or chemical, mechanical or laser etching.

6. Process according to one of the preceding claims, **characterised in that** the solid metallic support has a polished upper surface.

7. Process according to one of Claims 2 to 6, **characterised in that** removably fixed objects are placed on the solid metallic support after steps a) to e), and **in that** these objects are released from the solid metallic support when the metallic structures and the polymerised photoresist are being detached from the solid metallic support by delamination, so as to obtain monolayer metallic structures, or multilayer metallic structures with fully superimposed layers, comprising an inserted object.

8. Process according to one of Claims 2 to 6, **characterised in that** screws are placed in tapped holes of the solid metallic support after steps a) to e), these screws extending above the upper surface of the solid metallic support, and **in that** these screws are unscrewed when the metallic structures and the polymerised photoresist are being detached from the solid metallic support by delamination, so as to obtain monolayer metallic structures, or multilayer metallic structures with fully superimposed layers, comprising a threaded hole.

9. Machined monolayer metallic structure for clockwork movement obtained according to Claim 2 or one of Claims 4 to 8 dependent on Claim 2.

10. Machined monolayer metallic structure or machined multilayer metallic structure with fully superimposed layers, in which an insert is incorporated by the process according to Claim 7.

11. Machined monolayer metallic structure or machined multilayer metallic structure with fully superimposed layers, comprising a threaded hole formed by the process according to Claim 8.

12. Process for fabricating a monolayer metallic structure or multilayer metallic structure with fully superimposed layers by a LIGA type technology, which comprises the following steps:
a) spreading a layer of photoresist over a solid metallic substrate,
b) heating the layer of photoresist, if necessary, in order to evaporate the solvent,
c) exposing the layer of photoresist through a mask corresponding to the desired impression with 100 to 2000 mJ/cm² of UV radiation measured at a wavelength of 365 nm,
d) if necessary, in order to complete the photopolymerisation or photodecomposition, annealing the layer obtained after step c),
e) developing by dissolving the parts which have not been polymerised or photodecomposed,
f) electrolytically depositing a metal or an alloy in the open parts of the photoresist mould, and levelling by machining so as to obtain a plane upper surface,
then
g) in the case of a monolayer structure, if necessary, carrying out one or more other machining operations on the upper face of the electroformed mechanical structure, and
h) detaching the metallic structure and the polymerised photoresist from the solid metallic substrate by delamination, and separating the polymerised photoresist from the machined monolayer metallic structure;
or
g) in the case of a multilayer structure with superimposed layers, repeating steps a), b), c), d), e) and activating by electrochemical treatment the surface of the electroformed metal not covered with polymerised photoresist,
h) repeating step f),
i) if necessary, repeating steps g) and h),
j) if necessary, carrying out one or more other machining operations on the upper face of the electroformed mechanical structure, and
k) detaching the metallic structure and the polymerised photoresist from the solid metallic substrate by delamination, and separating the polymerised photoresist from the machined multilayer metallic structure with superimposed layers,
**characterised in that** a removably fixed object is placed above the solid metallic substrate after steps a) to e), and **in that** this object is released from the solid metallic substrate when the metallic structure and the polymerised photoresist are being detached from the solid metallic substrate by delamination, so as to obtain a monolayer metallic structure, or multilayer metallic structure with fully superimposed layers, comprising an inserted object.

13. Process for fabricating a monolayer metallic structure or multilayer metallic structure with fully superimposed layers by a LIGA type technology, which comprises the following steps:
a) spreading a layer of photoresist over a solid metallic substrate,
b) heating the layer of photoresist, if necessary, in order to evaporate the solvent,
c) exposing the layer of photoresist through a mask corresponding to the desired impression with 100 to 2000 mJ/cm² of UV radiation measured at a wavelength of 365 nm,
d) if necessary, in order to complete the photopolymerisation or photodecomposition, annealing the layer obtained after step c),
e) developing by dissolving the parts which have not been polymerised or photodecomposed,
f) electrolytically depositing a metal or an alloy in the open parts of the photoresist mould, and levelling by machining so as to obtain a plane upper surface,
then
g) in the case of a monolayer structure, if necessary, carrying out one or more other machining operations on the upper face of the electroformed mechanical structure, and
h) detaching the metallic structure and the polymerised photoresist from the solid metallic substrate by delamination, and separating the polymerised photoresist from the machined monolayer metallic structure;
or
g) in the case of a multilayer structure with superimposed layers, repeating steps a), b), c), d), e) and activating by electrochemical treatment the surface of the electroformed metal not covered with polymerised photoresist,
h) repeating step f),
i) if necessary, repeating steps g) and h),
j) if necessary, carrying out one or more other machining operations on the upper face of the electroformed mechanical structure, and
k) detaching the metallic structure and the polymerised photoresist from the solid metallic substrate by delamination, and separating the polymerised photoresist from the machined multilayer metallic structure with superimposed layers,
**characterised in that** a screw is placed in a tapped hole of the solid metallic substrate after steps a) to e), this screw extending above the upper surface of the solid metallic substrate, and **in that** the screw is unscrewed when the metallic structure and the polymerised photoresist are being detached from the solid metallic substrate by delamination, so as to obtain a monolayer metallic structure, or multilayer metallic structure with fully superimposed layers, comprising a threaded hole.

14. Machined monolayer metallic structure obtained according to Claim 12 or 13, **characterised in that** it is a piece of clockwork movement, in particular a spring.

15. Machined monolayer metallic structure, or machined multilayer metallic structure with fully superimposed layers, comprising an inserted object, **characterised in that** it can be obtained by a process according to Claim 12.

16. Machined monolayer metallic structure, or machined multilayer metallic structure with fully superimposed layers, comprising a threaded hole, **characterised in that** it can be obtained by a process according to Claim 13.

17. Machined multilayer metallic structure with fully superimposed layers which can be obtained by a process according to Claim 12 or 13, **characterised in that** it is an escapement anchor for clockwork movement.

## Patentansprüche

1. Verfahren zur Herstellung einer Anzahl von einlagigen oder mehrlagigen Metallstrukturen mit einer Technologie des LIGA-Typs, bei dem eine Photolackschicht auf einen massiven Metallträger aus rostfreiem Stahl aufgebracht wird, eine Photolackform durch Bestrahlung oder Elektronen- beziehungsweise Ionenbeschuss geschaffen wird, galvanisch ein Metall oder einer Legierung in dieser Form abgeschieden wird, die Metallstruktur mechanisch bearbeitet wird, die Struktur und der Photolack von dem massiven Metallträger abgetrennt werden sowie der Photolack beseitigt wird, **dadurch gekennzeichnet, dass** die Oberfläche des Trägers passiviert wird, um die Metallstruktur und den Photolack von dem massiven Metallträger durch Delaminieren zu entfernen.

2. Verfahren nach Anspruch 1 zur Herstellung einer Anzahl von bearbeiteten, einlagigen Metallstrukturen mit einer Technologie des UV-LIGA-Typs, das die folgenden Schritte umfasst:
a) Aufbringen einer Photolackschicht auf einen massiven Metallträger,
b) Erwärmen der Photolackschicht, falls zum Verdampfen des Lösungsmittels erforderlich,
c) Bestrahlen der Photolackschicht durch eine der gewünschten Matrize entsprechende Maske mit UV von 100 bis 2000 mJ/cm², gemessen bei einer Wellenlänge von 365 nm,
d) Anlassen der im Ergebnis des Schritts c) erhaltenen Schicht, falls dies für den Abschluss der Photopolymerisation oder Photozersetzung erforderlich ist,
e) Entwickeln durch Auflösen der nicht polymerisierten oder photozersetzten Anteile,
f) galvanisches Abscheiden eines Metalls oder einer Legierung in den offenen Abschnitten der Photolackform und Einebnen durch Bearbeitung, um eine ebene Oberseite zu erhalten,
g) Ausführen eines oder mehrerer weiterer Bearbeitungsschritte auf der Oberseite der elektrogeformten Metallstrukturen, falls erforderlich, und
h) Ablösen der Metallstrukturen und des polymerisierten Photolacks von dem massiven Metallträger durch Delaminieren sowie Abtrennen des polymerisierten Photolacks von den bearbeiteten, einlagigen Metallstrukturen.

3. Verfahren nach Anspruch 1 zur Herstellung einer Anzahl von bearbeiteten, mehrlagigen Metallstrukturen mit einander gänzlich überlagerten Schichten mit einer Technologie des UV-LIGA-Typs, das die folgenden Schritte umfasst:
a) Aufbringen einer Photolackschicht auf einen massiven Metallträger,
b) Erwärmen der Photolackschicht, falls zum Verdampfen des Lösungsmittels erforderlich,
c) Bestrahlen der Photolackschicht durch eine der gewünschten Matrize entsprechende Maske mit UV von 100 bis 2000 mJ/cm², gemessen bei einer Wellenlänge von 365 nm,
d) Anlassen der im Ergebnis des Schritts c) erhaltenen Schicht, falls dies für den Abschluss der Photopolymerisation oder Photozersetzung erforderlich ist,
e) Entwickeln durch Auflösen der nicht polymerisierten oder photozersetzten Anteile,
f) galvanisches Abscheiden eines Metalls oder einer Legierung in den offenen Abschnitten der Photolackform und Einebnen durch Bearbeitung, um eine ebene Oberseite zu erhalten,
g) Wiederholen der Schritte a), b), c), d) und e) sowie Aktivieren der nicht von polymerisiertem Photolack bedeckten Oberfläche des elektrogeformten Metalls durch eine elektrochemische Behandlung,
h) Wiederholen des Schritts f),
i) Wiederholen der Schritte g) und h), falls erforderlich,
j) Ausführen eines oder mehrerer weiterer Bearbeitungsschritte auf der Oberseite der elektrogeformten Metallstrukturen, falls erforderlich, und
k) Ablösen der Metallstrukturen und des polymerisierten Photolacks von dem massiven Metallträger durch Delaminieren sowie Abtrennen des polymerisierten Photolacks von den bearbeiteten, mehrlagigen Metallstrukturen mit einander überlagerten Schichten.

4. Verfahren nach einem der vorangehenden Ansprüche, bei dem nach dem Ablösen der Metallstrukturen von dem massiven Metallträger durch Delaminieren und vor dem Abtrennen des Photolacks auf den Metallstrukturen ein oder mehrere Gravur-, Oberflächenbehandlungs-, mechanische Markierungs- oder Lasermarkierungsschritte durchgeführt werden.

5. Verfahren nach einem der vorangehenden Ansprüche, **dadurch gekennzeichnet, dass** der massive Metallträger eine Oberseite besitzt, die durch Mikrokugelstrahlen, chemische Gravur, mechanische Gravur oder Lasergravur texturiert wurde.

6. Verfahren nach einem der vorangehenden Ansprüche, **dadurch gekennzeichnet, dass** der massive Metallträger eine polierte Oberseite besitzt.

7. Verfahren nach einem der Ansprüche 2 bis 6, **dadurch gekennzeichnet, dass** nach den Schritten a) bis e) auf dem massiven Metallträger abnehmbar befestigte Objekte angeordnet werden und dass während des Ablösens der Metallstrukturen und des polymerisierten Photolacks von dem massiven Metallträger durch Delaminieren diese Objekte von dem massiven Metallträger befreit werden, so dass einlagige oder mehrlagige Metallstrukturen mit einander gänzlich überlagerten Schichten hergestellt werden, die ein eingelagertes Objekt aufweisen.

8. Verfahren nach einem der Ansprüche 2 bis 6, **dadurch gekennzeichnet, dass** nach den Schritten a) bis e) Schrauben in Gewindelöcher des massiven Metallträgers eingesetzt werden, die über eine Oberseite des Trägers hervorstehen, und dass während des Ablösens der Metallstrukturen und des polymerisierten Photolacks von dem massiven Metallträger durch Delaminieren diese Schrauben herausgeschraubt werden, so dass einlagige oder mehrlagige Metallstrukturen mit einander gänzlich überlagerten Schichten hergestellt werden, die ein Gewindeloch aufweisen.

9. Bearbeitete, einlagige Metallstruktur eines Uhrwerks, die nach Anspruch 2 oder einem der vom Anspruch 2 abhängigen Ansprüche 4 bis 8 hergestellt ist.

10. Bearbeitete, einlagige oder mehrlagige Metallstruktur mit einander gänzlich überlagerten Schichten, in die ein Einsatz durch das Verfahren nach Anspruch 7 eingelagert ist.

11. Bearbeitete, einlagige oder mehrlagige Metallstruktur mit einander gänzlich überlagerten Schichten, die ein Gewindeloch aufweist, das durch das Verfahren nach Anspruch 8 gebildet ist.

12. Verfahren zur Herstellung einer einlagigen oder mehrlagigen Metallstruktur mit einander gänzlich überlagerten Schichten mit einer Technologie des LIGA-Typs, das die folgenden Schritte umfasst:
a) Aufbringen einer Photolackschicht auf ein Substrat aus massivem Metall,
b) Erwärmen der Photolackschicht, falls zum Verdampfen des Lösungsmittels erforderlich,
c) Bestrahlen der Photolackschicht durch eine der gewünschten Matrize entsprechende Maske mit UV von 100 bis 2000 mJ/cm², gemessen bei einer Wellenlänge von 365 nm,
d) Anlassen der im Ergebnis des Schritts c) erhaltenen Schicht, falls dies für den Abschluss der Photopolymerisation oder Photozersetzung erforderlich ist,
e) Entwickeln durch Auflösen der nicht polymerisierten oder photozersetzten Anteile,
f) galvanisches Abscheiden eines Metalls oder einer Legierung in den offenen Abschnitten der Photolackform und Einebnen durch Bearbeitung, um eine ebene Oberseite zu erhalten, dann
g) im Fall einer einlagigen Struktur Ausführen eines oder mehrerer weiterer Bearbeitungsschritte auf der Oberseite der elektrogeformten mechanischen Struktur, falls erforderlich, und
h) Ablösen der Metallstruktur und des polymerisierten Photolacks von dem Substrat aus massivem Metall durch Delaminieren sowie Abtrennen des polymerisierten Photolacks von der bearbeiteten, einlagigen Metallstruktur,
oder
g) im Fall einer mehrlagigen Struktur mit einander überlagerten Schichten Wiederholen der Schritte a), b), c), d) und e) sowie Aktivieren der nicht von polymerisiertem Photolack bedeckten Oberfläche des elektrogeformten Metalls durch eine elektrochemische Behandlung,
h) Wiederholen des Schritts f),
i) Wiederholen der Schritte g) und h), falls erforderlich,
j) Ausführen eines oder mehrerer weiterer Bearbeitungsschritte auf der Oberseite der elektrogeformten mechanischen Struktur, falls erforderlich, und
k) Ablösen der Metallstruktur und des polymerisierten Photolacks von dem Substrat aus massivem Metall durch Delaminieren sowie Abtrennen des polymerisierten Photolacks von der bearbeiteten, mehrlagigen Metallstruktur mit einander überlagerten Schichten,
**dadurch gekennzeichnet, dass** nach den Schritten a) bis e) über dem Substrat aus massivem Metall ein abnehmbar befestigtes Objekt angeordnet wird und dass während des Ablösens der Metallstruktur und des polymerisierten Photolacks von dem Substrat aus massivem Metall durch Delaminieren dieses Objekt von dem Substrat aus massivem Metall befreit wird, so dass eine einlagige oder mehrlagige Metallstruktur mit einander gänzlich überlagerten Schichten hergestellt wird, die ein eingelagertes Objekt aufweist.

13. Verfahren zur Herstellung einer einlagigen oder mehrlagigen Metallstruktur mit einander gänzlich überlagerten Schichten mit einer Technologie des LIGA-Typs, das die folgenden Schritte umfasst:
a) Aufbringen einer Photolackschicht auf ein Substrat aus massivem Metall,
b) Erwärmen der Photolackschicht, falls zum Verdampfen des Lösungsmittels erforderlich,
c) Bestrahlen der Photolackschicht durch eine der gewünschten Matrize entsprechende Maske mit UV von 100 bis 2000 mJ/cm², gemessen bei einer Wellenlänge von 365 nm,
d) Anlassen der im Ergebnis des Schritts c) erhaltenen Schicht, falls dies für den Abschluss der Photopolymerisation oder der Photozersetzung erforderlich ist,
e) Entwickeln durch Auflösen der nicht polymerisierten oder photozersetzten Anteile,
f) galvanisches Abscheiden eines Metalls oder einer Legierung in den offenen Abschnitten der Photolackform und Einebnen durch Bearbeitung, um eine ebene Oberseite zu erhalten, dann
g) im Fall einer einlagigen Struktur Ausführen eines oder mehrerer weiterer Bearbeitungsschritte auf der Oberseite der elektrogeformten mechanischen Struktur, falls erforderlich, und
h) Ablösen der Metallstruktur und des polymerisierten Photolacks von dem Substrat aus massivem Metall durch Delaminieren sowie Abtrennen des polymerisierten Photolacks von der bearbeiteten, einlagigen Metallstruktur,
oder
g) im Fall einer mehrlagigen Struktur mit einander überlagerten Schichten Wiederholen der Schritte a), b), c), d) und e) sowie Aktivieren der nicht von polymerisiertem Photolack bedeckten Oberfläche des elektrogeformten Metalls durch eine elektrochemische Behandlung,
h) Wiederholen des Schritts f),
i) Wiederholen der Schritte g) und h), falls erforderlich,
j) Ausführen eines oder mehrerer weiterer Bearbeitungsschritte auf der Oberseite der elektrogeformten mechanischen Struktur, falls erforderlich, und
k) Ablösen der Metallstruktur und des polymerisierten Photolacks von dem Substrat aus massivem Metall durch Delaminieren sowie Abtrennen des polymerisierten Photolacks von der bearbeiteten, mehrlagigen Metallstruktur mit einander überlagerten Schichten,
**dadurch gekennzeichnet, dass** nach den Schritten a) bis e) eine Schraube in ein Gewindeloch des Substrats aus massivem Metall eingesetzt wird, die über die Oberseite dieses Substrats hervorsteht, und dass während des Ablösens der Metallstruktur und des polymerisierten Photolacks von dem Substrat aus massivem Metall durch Delaminieren diese Schraube herausgeschraubt wird, so dass eine einlagige oder mehrlagige Metallstruktur mit einander gänzlich überlagerten Schichten hergestellt wird, die ein Gewindeloch aufweist.

14. Bearbeitete, einlagige Metallstruktur, die nach Anspruch 12 oder 13 hergestellt ist, **dadurch gekennzeichnet, dass** sie Teil eines Uhrwerks und insbesondere eine Feder ist.

15. Bearbeitete, einlagige oder mehrlagige Metallstruktur mit einander gänzlich überlagerten Schichten, ein eingelagertes Objekt umfassend und **dadurch gekennzeichnet, dass** sie durch ein Verfahren nach Anspruch 12 herstellbar ist.

16. Bearbeitete, einlagige oder mehrlagige Metallstruktur mit einander gänzlich überlagerten Schichten, ein Gewindeloch umfassend und **dadurch gekennzeichnet, dass** sie durch ein Verfahren nach Anspruch 13 herstellbar ist.

17. Bearbeitete, mehrlagige Metallstruktur mit einander gänzlich überlagerten Schichten, die durch ein Verfahren nach Anspruch 12 oder 13 herstellbar ist, **dadurch gekennzeichnet, dass** sie ein Anker der Hemmung für ein Uhrwerk ist.
